# EUROPÄISCHE PATENTSCHRIFT

(11) **EP 4 314 740 B1**
(45) Veröffentlichungstag und Bekanntmachung des Hinweises auf die Patenterteilung: **10.09.2025**
(21) Anmeldenummer: 22715101.6
(22) Anmeldetag: 22.03.2022
(51) Int. Cl.: G01J 5/0806, G02B 5/20, G02B 17/00, H10F 77/40, G01J 5/04, G02B 5/04, G02B 5/10, G01J 5/08, G02B 5/30, G02B 17/08, G01J 5/00

(54) **MEHRKANALIGER KATADIOPTRISCHER AUFBAU ZUR AUFNAHME EINES INFRAROTBILDES**
MULTICHANNEL CATADIOPTRIC SYSTEM FOR CAPTURING AN INFRARED IMAGE
SYSTÈME CATADIOPTRIQUE MULTICANAL POUR CAPTURE D'UNE IMAGE INFRAROUGE

(30) Priorität: 23.03.2021 DE 102021202841
(43) Veröffentlichungstag der Anmeldung: 07.02.2024
(73) Patentinhaber: Fraunhofer-Gesellschaft zur Förderung der angewandten Forschung e.V., 80686 München (DE)
(72) Erfinder: BRÜNING, Robert, 07745 Jena (DE); LEITEL, Robert, 07745 Jena (DE); HUBOLD, Martin, 07745 Jena (DE); QUENZER, Hans-Joachim, 25524 Itzehoe (DE); WEILER, Dirk, 47057 Duisburg (DE)
(74) Vertreter: Schlenker, Julian
(86) Internationale Anmeldenummer: PCT/EP2022/057461
(87) Internationale Veröffentlichungsnummer: WO 2022/200331

(56) Entgegenhaltungen:
- MAS ADRIEN ET AL: "Study of asymmetric or decentered multi-view designs for uncooled infrared imaging applications", OPTICS EXPRESS, vol. 28, no. 23, 5 November 2020 (2020-11-05), pages 35216, XP055926959, Retrieved from the Internet <URL:https://opg.optica.org/DirectPDFAccess/4EAFDDAB-A535-49E2-B9D833494E8FF7A3_442329/oe-28-23-35216.pdf?da=1&id=442329&seq=0&mobile=no> DOI: 10.1364/OE.408442
- ANDREAS BRU"CKNER ET AL: "Multi-aperture optics for wafer-level cameras", JOURNAL OF MICRO NANOLITHOGRAPHY MEMS AND MOEMS, 21 November 2011 (2011-11-21), pages 43010, XP055128787, Retrieved from the Internet <URL:http://dx.doi.org/> DOI: 10.1117/1.3659144

## Beschreibung

Ausführungsbeispiele der vorliegenden Erfindung beziehen sich auf einen mehrkanaligen katadioptrischen Aufbau zur Aufnahme eines Infrarotbildes. Weitere Ausführungsbeispiele beziehen sich auf ein katadioptrisches System mit segmentiertem Bildfeld.

Es sind ungekühlte FIR (FIR = Fernes Infrarot) Kamerasysteme bekannt. Diese haben in der Regel eine Pixelgröße von 12 bis 17 µm (z.B. für Wellenlängen von 8 bis 14 µm) und basieren auf einer speziellen Mikrobolometertechnologie in Verbindung mit Packaging-Techniken zur Vakuumverkapselung der FIR-Bildaufnehmer-Chips. Solche FIR Kameras weisen eine hohe IR-Abbildungsqualität (IR = Infrarot), aber vergleichsweise große Abmessungen (Chipgröße, Objektivbaugröße) und hohe Systemkosten auf. Hierbei sind die verwendeten FIR-Objektive rein transmittiv und benötigen sehr lichtstarke Objektive, wodurch diese eine große Baugröße mit einem hohen Gewicht aufweisen. Wenn die Brennweite des Objektives und/oder wenn ein größerer Bildaufnehmerchip verwendet werden soll (z.B. bei größerer Pixelanzahl), dann muss der Durchmesser des Objektives mit anwachsen, um die Lichtstärke gleich zu belassen. Da die Kosten für Objektive etwa mit der dritten Potenz des Durchmessers anwachsen, explodieren die Kosten wenn größere Brennweiten oder höhere Auflösungen gefordert sind.

Aus der Automobiltechnik ist ein Vanadiumoxid-Mikrobolometerarray mit 336 x 256 Pixeln bei 17 µm Pitch bekannt [1], wobei die Objektive aus zwei Ge-Linsen und zwei planparallelen Fenstern bestehen. Zudem ist aus der Automobiltechnik eine ungekühlte FIR-Wärmebildkamera mit 384 x 288 Pixeln aus amorphem Silizium bekannt.

Ferner sind kompakte FIR-Kameramodelle bekannt. Aus [2] ist eine FIR Kamera mit einer Pixelgröße von 12 µm, bis zu 640 x 512 Pixeln und einem kompakten Kameravolumen <5 cm³ (ohne Objektiv) bekannt. Ferner sind voll-integrierte FIR Kameras mit 160 x 120 Pixeln mit einem zweilinsigen Objektiv mit einer optischen Öffnung von 2,5 mm bekannt. Diese übernehmen Aufbau- und Verbindungstechniken (AVT) und Wafer-Level-Packaging Technologien (WLP) aus dem MEMS Bereich (MEMS = Microelectromechanical System, dt. Mikrosystem): (1) eine WLP Integration des Vakuum Gehäuses, (2) eine Einschränkung der begrenzten Transmissionseigenschaften Silizium, und (3) der Transferprozess, welcher zu einer eingeschränkten Pfeilhöhen der Linsen führt [3], was bei kleinen Auflösungen noch in Ordnung ist, für größere Auflösung jedoch große Linsen bei großem Öffnungsverhältnis erfordert, was nicht wirtschaftlich herstellbar ist. Des Weiteren ist aus [4] eine "Superauflösung" (engl. Superresolution) mittels eines Linsenarrays bekannt, wobei jeweils ein niedrig abgetastetes Bild des gesamten Gesichtsfeldes aufgenommen und ein gemeinsamer VGA-Chip verwendet wird.

Zur Herstellung von Linsen ist Blankpressen von Chalkogenid-Linsen [5] oder Ultrapräzision-Diamant-Drehen oder Schleifen und Polieren von Germaniumlinsen bekannt, was jedoch jeweils zu hohen Prozesskosten führt.

Des Weiteren ist eine Segmentierung des Gesichtsfeldes (rein transmittiv) bekannt: (1) an gekühlter MIR-Kamera [6, 7, 8] (MIR = mittleres Infrarot) mit Quarzglas-Mikrolinsen-Array mit parallelen optische Achsen im Wellenlängenbereich von 3-5 µm, (2) zusätzliches Prismenarray [6], um das Sichtfeld (engl. field-of-view, FOV) auf 30° zu vergrößern, dieses ist jedoch nicht kompakt (Bauhöhe ca. 25 mm), weist eine geringe Lichtempfindlichkeit (jeder Teleskopkanal ist äquivalent zu Linse mit f/8, geringe Transmission Quarzglas im Wellenlängenbereich 3-5 µm) und ein stark limitiertes Auflösungsvermögen durch geringe Optikdurchmesser auf, und (3) diamant-gedrehte Fresnel-Linse höherer Ordnung [9], wobei eine gekühlte MIR-Kamera mit einer Pixelgröße von 15 µm, einer Blendenzahl von vier, einem Sichtfeld (engl. field of view) von ± 30° und 500 µm dickes Germanium zum Einsatz kommt.

Aus der US 2002/104968 A1 ist ein zwei-Spiegler-System bekannt. Es kommt ein Cassegrain Objektiv (Zwei-Spiegler) zum Einsatz, welches reflektiv ist. Beide Spiegel sind in Plastik gegossen und beschichtet, wobei ein Temperaturausdehnungskoeffizient von Plastik höher ist als ein Temperaturausdehnungskoeffizient von Glas oder Silizium (ca. Faktor 10-20), was zu einer Änderung der Performance unter einem Temperatureinfluss führt. Bei dem System ist eine Ausrichtung über eine Einrast-Funktion realisiert und der Bildaufnehmer muss hinter den Spiegeln verkapselt sein. Dieses System ist ungeeignet für eine Parallelisierung und Gesichtsfeldvergrößerung.

Aus der US 2017/230590 A1 ist ein Infrarot Abbildungssystem und Methode bekannt, wobei ein multi-modales infrarot Abbildungssystem mit infrarot optischen Fenster zum Einsatz kommt, was zu einem großen Gesichtsfeld führt, jedoch werden 2D-Scan Spiegel mit verschleißanfälligen, beweglichen Teilen benötigt.

Aus der US 2009/041292 A1 ist eine Multi-Kanal Radiometer Abbildungsmethode und - system bekannt, welche eine Scaneinheit zur Reflektion von Millimeterwellenlängen beinhaltet.

Zusammenfassend sind ungekühlte Wärmebildkameras mit VGA-Auflösung in ihrer Bauform sehr groß und nicht besonders kompakt, um die FIR-Bildaufnehmer (fern Infrarot, Wellenlänge 8-14 µm) voll auszuleuchten. Außerdem kommen große, schwere und teure Germanium oder Chalkogenid-Gläser zum Einsatz, welche für eine lichtstarke Optik benötigt werden. Diese fallen jedoch unter die RoHS-Richtlinien und können auf lange Sicht u.U. nicht mehr eingesetzt werden. Die sehr hohe Absorption von Silizium im Bereich von 8-14 µm beschränkt den Einsatz von Silizium in der waferbasierten Herstellung, da Linsen mit sehr großer Pfeilhöhe für eine hohe Lichtstärke benötigt werden. Alternative Ansätze nutzen scannende Spiegeloptiken zur Erweiterung des Gesichtsfelds.

In [10] werden asymmetrische und dezentrierte Mehrfachansicht-Entwürfe für ungekühlte Infrarot-Bildgebungsanwendungen beschrieben.

In [11] wird eine Mehrfachaperturoptik für Kameras auf Waferebene beschrieben.

Der vorliegenden Erfindung liegt somit die Aufgabe zugrunde, ein kostengünstigeres Konzept zu schaffen, welches eine Aufnahme eines Infrarotbildes mit höherer Auflösung ermöglicht.

Diese Aufgabe wird durch die unabhängigen Patentansprüche gelöst.

Vorteilhafte Weiterbildungen finden sich in den abhängigen Patentansprüchen.

Ausführungsbeispiele schaffen einen mehrkanaligen katadioptrischen Aufbau zur Aufnahme eines Infrarotbildes [z.B. Wärmebildes]. Der mehrkanalige katadioptrische Aufbau umfasst eine Mehrzahl von optischen Korrekturelementen, eine Mehrzahl von optischen Detektoren [z.B. Bildaufnehmer; z.B. jeweils mit einer Mehrzahl von Pixeln], und eine Mehrzahl von optischen Spiegelelementen, wobei die Mehrzahl von optischen Detektoren jeweils an einem der Mehrzahl von optischen Korrekturelementen angebracht oder integriert sind und jeweils zwischen einem der Mehrzahl von optischen Korrekturelementen und einem der Mehrzahl von optischen Spiegelelementen verkapselt sind, wobei jeweils einer der Mehrzahl von optischen Detektoren zusammen mit einem jeweiligen optischen Korrekturelement und einem jeweiligen optischen Spiegelelement einen Kanal des mehrkanaligen katadioptrischen Aufbaus bilden, wobei die Mehrzahl von optischen Korrekturelementen auf einem gemeinsamen Korrekturelementträger gebildet sind und/oder wobei die Mehrzahl von optischen Spiegelelementen auf einem gemeinsamen Spiegelelementträger gebildet sind. Bei Ausführungsbeispielen können die Mehrzahl von optischen Detektoren ausgebildet sein, um jeweils einen unterschiedlichen Bildausschnitt [z.B. Teilbild] des Infrarotbildes aufzunehmen, wobei eine zusammengesetzte Version der unterschiedlichen Bildausschnitte das Infrarotbild bildet.

Bei Ausführungsbeispielen können zumindest zwei der Mehrzahl von optischen Detektoren ausgebildet sein, um denselben Bildausschnitt [z.B. Teilbild] des Infrarotbildes aufzunehmen.

Erfindungsgemäss ist die Mehrzahl von optischen Spiegelelementen ausgebildet, um einen jeweiligen Bildausschnitt des Infrarotbildes, der durch ein jeweiliges optisches Korrekturelement auf das jeweilige optische Spiegelelement abgebildet wird, auf einen jeweiligen optischen Detektor abzubilden.

Bei Ausführungsbeispielen können die Mehrzahl von optischen Korrekturelementen ausgebildet sein, um eine Abbildung zu verbessern und/oder ein Sichtfeld des Infrarotbildes aufzuweiten.

Bei Ausführungsbeispielen können die Mehrzahl von optischen Detektoren in einem eindimensionalen oder zweidimensionalen Array angeordnet sein.

Bei Ausführungsbeispielen können die Mehrzahl von optischen Korrekturelementen und/oder die Mehrzahl von optischen Spiegelelementen in einem festen Verbund angeordnet sein.

Bei Ausführungsbeispielen können die Mehrzahl von optischen Korrekturelementen in einer gemeinsamen Ebene [z.B. optischen Korrekturelementebene] angeordnet sein.

Bei Ausführungsbeispielen können die Mehrzahl von optischen Detektoren in einer gemeinsamen Ebene [z.B. optischen Detektorebene] angeordnet sein.

Bei Ausführungsbeispielen können die Mehrzahl von optischen Spiegelelementen in einer gemeinsamen Ebene [z.B. optischen Spiegelelementebene] angeordnet sein.

Bei Ausführungsbeispielen können der Korrekturelementträger und der Spiegelelementträger über einen Abstandshalter verbunden sein.

Bei Ausführungsbeispielen kann der Abstandhalter für den Nutzwellenlängenbereich der optischen Detektoren optisch undurchlässig sein.

Bei Ausführungsbeispielen können der Korrekturelementträger, Spiegelelementträger und der Abstandshalter ein gekapseltes Gehäuse für die Mehrzahl von optischen Detektoren bilden.

Bei Ausführungsbeispielen kann das gekapselte Gehäuse gasdicht realisiert sein und im Inneren ein Vakuum, Inertgas oder Schutzgas enthalten.

Bei Ausführungsbeispielen kann das gekapselte Gehäuse hermetisch dicht sein [z.B. (Helium dicht) nach MIL Standard Helium Leck rate kleiner als 10-8 I*mbar /s].

Bei Ausführungsbeispielen können der Korrekturelementträger, Spiegelelementträger und Abstandshalter den gleichen thermischen Ausdehnungskoeffizienten oder aufeinander abgestimmte thermische Ausdehnungskoeffizienten aufweisen.

Bei Ausführungsbeispielen können die Mehrzahl von Korrekturelementen eine refraktive und/oder diffraktive optische Funktionalität aufweisen.

Bei Ausführungsbeispielen können die Mehrzahl von Korrekturelementen eine Freiform- oder eine Fresnel-Struktur aufweisen.

Bei Ausführungsbeispielen können die reflektiven Spiegelelemente sphärische Oberflächenprofile, asphärische Oberflächenprofile und/oder Freiformoberflächenprofile aufweisen.

Bei Ausführungsbeispielen können die optischen Detektoren Fokalebenensensorelemente, Bolometer, halbleiterbasierte Detektoren [z.B. PbS, PbSe, InGaAs, Nanoröhren], pyroelektrische Detektoren oder Thermopile oder Kombinationen davon sein.

Bei Ausführungsbeispielen können die Mehrzahl von optischen Detektoren an der Mehrzahl von optischen Korrekturelementen an unterschiedlichen Positionen angebracht sein, um jeweils einen unterschiedlichen Bildausschnitt des Infrarotbildes aufzunehmen.

Bei Ausführungsbeispielen können die Mehrzahl von Spiegelelementen ausgebildet sein, um jeweils einen unterschiedlichen Bildausschnitt des Infrarotbildes auf den jeweiligen optischen Detektor abzubilden.

Bei Ausführungsbeispielen kann der mehrkanalige katadioptrische Aufbau eine Mehrzahl von Prismen aufweisen, die benachbart zu der Mehrzahl von Korrekturelementen angeordnet sind oder in die Mehrzahl von Korrekturelementen integriert sind, so dass Mehrzahl von optischen Detektoren jeweils einen unterschiedlichen Bildausschnitt des Infrarotbildes aufnehmen.

Bei Ausführungsbeispielen können die Mehrzahl von Prismen auf oder in einem gemeinsamen Prismenträger gebildet sein.

Bei Ausführungsbeispielen kann der mehrkanalige katadioptrische Aufbau ferner eine Mehrzahl von optischen Filtern aufweisen, die in den optischen Korrekturelementen oder den optischen Spiegelelementen integriert sind.

Bei Ausführungsbeispielen können die Mehrzahl von optischen Filtern spektralselektiv und/oder polarisationsselektiv sein.

Bei Ausführungsbeispielen können die Mehrzahl von optischen Korrekturelementen entspiegelt sein [z.B. ein- oder beidseitig].

Bei Ausführungsbeispielen können die Mehrzahl von optischen Korrekturelementen aus Silizium, Germanium oder Chalcogenidgläsern gefertig sein.

Bei Ausführungsbeispielen können die Mehrzahl von optischen Spiegelelementen eine Reflexion von mehr als 90% des Nutzwellenlängenbereichs der optischen Detektoren aufweisen.

Weitere Ausführungsbeispiele schaffen ein Verfahren zum Aufnehmen eines Infrarotbildes. Das Verfahren umfasst einen Schritt des Aufnehmens des Infrarotbildes mit einem mehrkanaligen katadioptrischen Aufbau, wobei der mehrkanalige katadioptrische Aufbau eine Mehrzahl von optischen Korrekturelementen, eine Mehrzahl von optischen Detektoren und eine Mehrzahl von optischen Spiegelelementen aufweist, wobei die Mehrzahl von optischen Detektoren jeweils an einem der Mehrzahl von optischen Korrekturelementen angebracht sind und jeweils zwischen einem der Mehrzahl von optischen Korrekturelementen und einem der Mehrzahl von optischen Spiegelelementen verkapselt sind, wobei jeweils einer der Mehrzahl von optischen Detektoren zusammen mit einem jeweiligen optischen Korrekturelement und einem jeweiligen optischen Spiegelelement einen Kanal des mehrkanaligen katadioptrischen Aufbaus bilden.

Bei Ausführungsbeispielen kann das Verfahren ferner einen Schritt des Zusammensetzens der von den optischen Detektoren erfassten Bildausschnitte, um das Infrarotbild zu erhalten, umfassen.

Ausführungsbeispiele schaffen einen mehrkanaligen katadioptrischen Aufbau (z.B. eine katadioptrische Multiaperturanordnung (mehrkanalige Kombination von Linsen und Spiegeloptik)) für lichtstarke FIR-Optik mit wenigen thermischen Aberrationen mit fokussierendem achromatischen Spiegelelement und refraktiver/n Freiformoptik(en) als Aberrationskorrektur.

Bei Ausführungsbeispielen ermöglichen eine Segmentierung des Gesichtsfelds und gefaltete Strahlengänge eine Reduktion der Aufbauhöhe und eine technisch einfache Korrektur von Aberrationen aufgrund kleinerer Teil-Bildfelder.

Bei Ausführungsbeispielen dient das refraktive Korrekturelement gleichzeitig als IRtransparentes Fenster für die aus Spiegelelement und Abstandshaltern gebildete Kavität, die den Betrieb von FPAs (Focal Plane Arrays) in Vakuum, z.B. für Mikrobolometer, oder Schutzgas, z.B. für gekühlte Sensoren (H2O-Kondensation) ermöglicht.

Bei Ausführungsbeispielen kann das refraktive Korrekturelement auch eine rein ablenkende Wirkung aufweisen oder kann mit verschiedenen optischen Filterschichten (Spektral, Polarisation) für den multi- oder hyperspektralen Multi-Aperturbetrieb oder Polarisationsbetrieb ausgestattet sein.

Bei Ausführungsbeispielen ermöglicht die Dimensionierung der Optik die Herstellung und Integration der optischen Komponenten im Wafermaßstab mit aussichtsreichen Auswirkungen auf Skalierbarkeit, Kosten und Zuverlässigkeit.

Bei Ausführungsbeispielen wird das von einer Szene auf die Kamera einfallende Licht durch das Korrekturelement abgelenkt und trifft auf den reflektierenden Freiformspiegel. Dieser fokussiert das Licht auf den Bildaufnehmer, welcher an der Rückseite des Korrekturelements befestigt und elektrisch kontaktiert ist.

Ausführungsbeispiele schaffen einen mehrkanaligen katadioptrischen Aufbau (z.B. katadioptrische Multiaperturanordnung) mit segmentiertem Bildfeld, wobei der mehrkanalige katadioptrische Aufbau gleichartige und/oder unterschiedliche Einzelkanäle aufweist, die im Wesentlichen (jeweils) folgende Merkmale umfassen:
- einen Bildaufnehmer/FPAs (FPAs = Focal Plane Arrays, dt. Fokalebenenarrays),
- ein optisches Korrektur- bzw. Ablenkelement und/oder ein Filterelement, und
- einen achromatischen reflektiven Freiformspiegel.

Bei Ausführungsbeispielen erfolgt eine Dimensionierung, Herstellung und Integration der optischen, elektronischen, und/oder mechanischen Komponenten im Wafermaßstab.

Bei Ausführungsbeispielen weist der mehrkanalige katadioptrische Aufbau optional ein vorgeschaltetes Arrayelement zur Strahllenkung, realisiert ggf. als vorgeschaltete Prismenplatte, ggf. als integriert in Korrekturplatte, auf.

Bei Ausführungsbeispielen kann das refraktive Korrekturelement folgende möglichen Formeigenschaften aufweisen:
- Freiform, und/oder
- Fresnel-Struktur.

Bei Ausführungsbeispielen können folgenden Arten von optischen Filterschichten auf dem Korrekturelement bzw. als separates Filterelement zum Einsatz kommen:
- spektralselektiv,
- polarisationsselektiv, und/oder
- Mischformen.

Bei Ausführungsbeispielen ist das Material des Korrekturelements in seinen optischen Eigenschaften (Transmission, Brechungsindex etc.) sowie eventuelle optische Filterschichten möglichst gut auf den adressierten Wellenlängenbereich der Kamera und des Bildaufnehmers abgestimmt.

Bei Ausführungsbeispielen können die (Freiform-)Spiegel folgende Formeigenschaften aufweisen:
- sphärisches Oberflächenprofil (inkl. Krümmungsradius und Konik),
- asphärisches Oberflächenprofil (rotationssymmetrische Polynombeschreibung), und/oder
- Freiformoberflächenprofil (jegliches 3D-Profil, keine Symmetrie).

Bei Ausführungsbeispielen können folgende Arten von Bildaufnehmern zum Einsatz kommen:
- ungekühlte IR-Bildaufnehmer (Focal Plane Arrays, dt. Fokalebenenarrays), wie z.B. Mikrobolometer aus z.B. Vanadiumoxid, amorphem Silizium; Diodenbolometer, etc.,
- gekühlte IR-Bildaufnehmer, wie z.B. MCT (MCT = mercury cadmium tellurid, dt. Quecksilber-Cadmium-Tellurid), PbS (Bleisulfid), PbSe (Bleiselenid), InGaAs (Indium Gallium Arsenid),
- pyroelektrische Detektoren,
- Thermopile, oder
- VIS-Bildaufnehmer (VIS = visuelles Spektrum), NIR- Bildaufnehmer (NIR = nahes Infrarot), SWIR- Bildaufnehmer (SWIR = kurzwelliges Infrarot), MWIR- Bildaufnehmer (MWIR = mittleres Infrarot), LWIR- Bildaufnehmer (LWIR = langwelliges Infrarot).

Bei Ausführungsbeispielen kann der mehrkanalige katadioptrische Aufbau ein lineares oder zweidimensionales Array aus gleichartigen und/oder unterschiedlichen Einzelzellen aufweisen, realisiert ggf. durch z.B. unterschiedliches Gesichtsfeld / Brennweite, F-Zahl, Aperturdurchmesser, etc.

Bei Ausführungsbeispielen kann der mehrkanalige katadioptrische Aufbau modular an adressierte Bild-Aspektverhältnis anpassbar sein.

Bei Ausführungsbeispielen kann eine Blickrichtung (z.B. bestimmt durch einen Chief Ray (dt. Hauptstrahl) auf den Mittelpunkt des Bildaufnehmers) der einzelnen Kanäle des mehrkanaligen katadioptrischen Aufbaus
- divergent (vergrößerndes Gesichtsfeld, teilweise überlappend, insbesondere für 3D-Karten im Nahbereich vorteilhaft),
- parallel (konstantes Gesichtsfeld pro Kanal, was den Vorteil hat, dass zusätzliche optische Filtereigenschaften integrierbar sind), und/oder
- konvergent (Überlappung der Gesichtsfelder, was für 3D-Karten vorteilhaft ist)
sein.

Bei Ausführungsbeispielen kann eine Verspiegelung (z.B. Gold, etc) des Freiformspiegels auf den adressierten Wellenlängenbereich angepasst sein.

Bei Ausführungsbeispielen kann eine Entspiegelung aller refraktiver Flächen zur Verhinderung von Rückreflexen sowie zur Erhöhung der Lichttransmission (Antireflexionsschicht) zum Einsatz kommen.

Ausführungsbeispiele der vorliegenden Erfindung werden bezugnehmend auf die beiliegenden Figuren näher beschrieben. Es zeigen:
- Fig. 1: eine schematische Querschnittsansicht eines mehrkanaligen katadioptrischen Aufbaus zur Aufnahme eines Infrarotbildes, gemäß einem Ausführungsbeispiel der vorliegenden Erfindung,
- Fig. 2: eine schematische Seitenansicht eines Einzelkanals des mehrkanaligen katadioptrischen Aufbaus aus Fig.1 im Schnitt, gemäß einem Ausführungsbeispiel der vorliegenden Erfindung,
- Fig. 3: eine schematische Seitenansicht des mehrkanaligen katadioptrischen Aufbaus für drei exemplarische Kanäle zur Demonstration des segmentierten Gesichtsfeldes, gemäß einem Ausführungsbeispiel der vorliegenden Erfindung,
- Fig. 4: eine dreidimensionale Ansicht des mehrkanaligen katadioptrischen Aufbaus exemplarisch für 2 x 3 Kanäle, gem. einem Ausführungsbeispiel der vorliegenden Erfindung,
- Fig. 5: eine schematische Querschnittansicht des mehrkanaligen katadioptrischen Aufbaus mit zusätzlichen Prismen, gemäß einem Ausführungsbeispiel der vorliegenden Erfindung,
- Fig. 6: eine schematische Querschnittansicht des mehrkanaligen katadioptrischen Aufbaus mit unterschiedlichen ausgebildeten optischen Korrekturelementen, gemäß einem Ausführungsbeispiel der vorliegenden Erfindung,
- Fig. 7: eine schematische Querschnittansicht des mehrkanaligen katadioptrischen Aufbaus mit unterschiedlichen angeordneten optischen Detektoren, gemäß einem Ausführungsbeispiel der vorliegenden Erfindung,
- Fig. 8: eine Frontalansicht eines exemplarischen 2 x 2 Arrays des mehrkanaligen katadioptrischen Aufbaus, gem. einem Ausführungsbeispiel der vorliegenden Erfindung, und
- Fig. 9: eine schematische Querschnittansicht des mehrkanaligen katadioptrischen Aufbaus mit unterschiedlichen ausgebildeten optischen Spiegelelementen, gemäß einem Ausführungsbeispiel der vorliegenden Erfindung.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

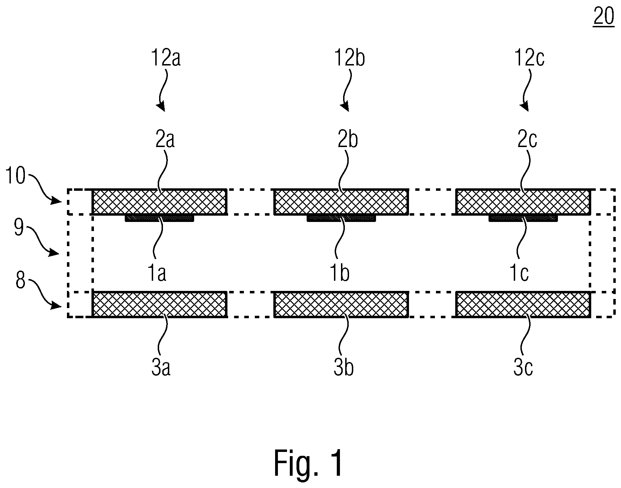

Fig. 1 zeigt eine schematische Querschnittsansicht eines mehrkanaligen katadioptrischen Aufbaus 20 zur Aufnahme eines Infrarotbildes gemäß einem Ausführungsbeispiel der vorliegenden Erfindung. Der mehrkanalige katadioptrische Aufbau 20 umfasst eine Mehrzahl von optischen Korrekturelementen 2a-2c, eine Mehrzahl von optischen Detektoren 1a-1c (z.B. Bildaufnehmer; z.B. jeweils mit einer Mehrzahl von Pixeln), und eine Mehrzahl von optischen Spiegelelementen 3a-3c, wobei jeweils ein optischer Detektor 1a der Mehrzahl von optischen Detektoren 1a-1c an einem jeweiligen optischen Korrekturelement 2a der Mehrzahl von optischen Korrekturelementen 2a-2c angebracht oder integriert ist, und zwischen dem jeweiligen optischen Korrekturelement 2a und einem jeweiligen optischen Spiegelelement 3a der Mehrzahl von optischen Spiegelelementen 3a-3c verkapselt ist, wobei jeweils ein optischer Detektor 1a der Mehrzahl von optischen Detektoren 1a-1c zusammen mit einem jeweiligen optischen Korrekturelement 2a und einem jeweiligen optischen Spiegelelement 3a einen Kanal 12a des mehrkanaligen katadioptrischen Aufbaus 20 bilden.

In dem in Fig. 1 gezeigten Ausführungsbeispiel weist der mehrkanalige katadioptrische Aufbau 20 zu Veranschaulichungszwecken beispielhaft drei optische Korrekturelemente 2a-2c, drei optische Detektoren 1a-1c und drei optische Spiegelelemente 3a-3c auf. Ein erster optischer Detektor 1a ist hierbei an einem ersten optischen Korrekturelement 2a angebracht oder integriert, und zwischen dem ersten optischen Korrekturelement 2a und einem ersten optischen Spiegelelement 3a verkapselt. Ein zweiter optischer Detektor 1b ist an einem zweiten optischen Korrekturelement 2b angebracht oder integriert, und zwischen dem zweiten optischen Korrekturelement 2b und einem zweiten optischen Spiegelelement 3b verkapselt. Ein dritter optischer Detektor 1c ist an einem dritten optischen Korrekturelement 2c angebracht oder integriert, und zwischen dem dritten optischen Korrekturelement 2c und einem dritten optischen Spiegelelement 3c verkapselt. Das erste optische Korrekturelement 2a, der erste optische Detektor 1a und das erste optische Spiegelelement 3a können hierbei einen ersten Kanal 12a des mehrkanaligen katadioptrischen Aufbaus 20 bilden, während das zweite optische Korrekturelement 2b, der zweite optische Detektor 1b und das zweite optische Spiegelelement 3b einen zweiten Kanal 12b des mehrkanaligen katadioptrischen Aufbaus 20 bilden können, während das dritte optische Korrekturelement 2c, der dritte optische Detektor 1c und das dritte optische Spiegelelement 3b einen dritten Kanal 12c des mehrkanaligen katadioptrischen Aufbaus 20 bilden können.

Es sei jedoch darauf hingewiesen, dass die Erfindung nicht auf solche Ausführungsbeispiele beschränkt ist. Vielmehr kann der mehrkanalige katadioptrische Aufbau 20 gem. Ausführungsbeispielen bis zu n Kanäle aufweisen, wobei n eine natürliche Zahl größer gleich drei ist, n ≥ 3. Jeder der Kanäle kann hierbei ein optisches Korrekturelement, einen optischen Detektor und ein optisches Spiegelelement aufweisen.

Bei Ausführungsbeispielen können die Mehrzahl von optischen Korrekturelementen 2a-2c und/oder die Mehrzahl von optischen Detektoren 1a-1c und/oder die Mehrzahl von optischen Spiegelelementen 3a-3c in einer jeweiligen gemeinsamen Ebene angeordnet sein.

Bei Ausführungsbeispielen können die Mehrzahl von optischen Detektoren 1a-1c in einem eindimensionalen oder zweidimensionalen Array angeordnet sein.

Bei Ausführungsbeispielen können die Mehrzahl von optischen Korrekturelementen 2a-2c und/oder die Mehrzahl von optischen Spiegelelementen 3a-3c in einem festen Verbund angeordnet sein, wie dies in Fig. 1 angedeutet ist.

Beispielsweise können bei Ausführungsbeispielen die Mehrzahl von optischen Korrekturelementen 2a-2c in oder auf einem gemeinsamen Korrekturelementträger 10 gebildet sein.

Alternativ oder zusätzlich können bei Ausführungsbeispielen die Mehrzahl von optischen Spiegelelementen 3a-3c auf einem gemeinsamen Spiegelelementträger 8 gebildet sein.

Bei Ausführungsbeispielen können der Korrekturelementträger 10 und der Spiegelelementträger 8 über einen Abstandshalter 9 verbunden sein.

Beispielsweise können der Korrekturelementträger 10, der Spiegelelementträger 8 und der Abstandshalter 9 ein gekapseltes (z.B. hermetisch dichtes) Gehäuse für die Mehrzahl von optischen Detektoren 1a-1c bilden, welches zum Beispiel gasdicht (oder hermetisch dicht) realisiert ist und im Inneren ein Vakuum, Inertgas oder Schutzgas enthält.

Bei Ausführungsbeispielen können die Mehrzahl von optischen Detektoren 1a-1c ausgebildet sein, um jeweils einen unterschiedlichen Bildausschnitt (z.B. ein Teilbild) des Infrarotbildes aufzunehmen, wobei eine zusammengesetzte Version der unterschiedlichen Bildausschnitte das Infrarotbild bildet.

Alternativ können bei Ausführungsbeispielen zumindest zwei der Mehrzahl von optischen Detektoren 1a-1c ausgebildet sein, um denselben Bildausschnitt [z.B. Teilbild] des Infrarotbildes aufzunehmen.

Bei Ausführungsbeispielen können die Mehrzahl von optischen Spiegelelementen 3a-3c ausgebildet sind, um einen jeweiligen Bildausschnitt des Infrarotbildes, der durch ein jeweiliges optisches Korrekturelement auf das jeweilige optische Spiegelelement abgebildet wird, auf einen jeweiligen optischen Detektor abzubilden.

Bei Ausführungsbeispielen können die Mehrzahl von optischen Korrekturelementen 2a-2c ausgebildet sein, um eine Abbildung zu verbessern und/oder ein Sichtfeld des Infrarotbildes aufzuweiten.

Bei Ausführungsbeispielen können die Mehrzahl von optischen Korrekturelementen 2a-2c eine Freiform- oder eine Fresnel-Struktur aufweisen.

Bei Ausführungsbeispielen können die Mehrzahl von optischen Spiegelelementen 3a-3c sphärische Oberflächenprofile, asphärische Oberflächenprofile und/oder Freiformoberflächenprofile aufweisen.

Bei Ausführungsbeispielen können die optischen Detektoren Fokalebenensensorelemente, Bolometer, halbleiterbasierte Detektoren (z.B. PbS, PbSe, InGaAs, Nanoröhren), pyroelektrische Detektoren oder Thermopile oder Kombinationen davon sein.

Im Folgenden werden weitere Ausführungsbeispiele des mehrkanaligen katadioptrischen Aufbaus 20 beschrieben.

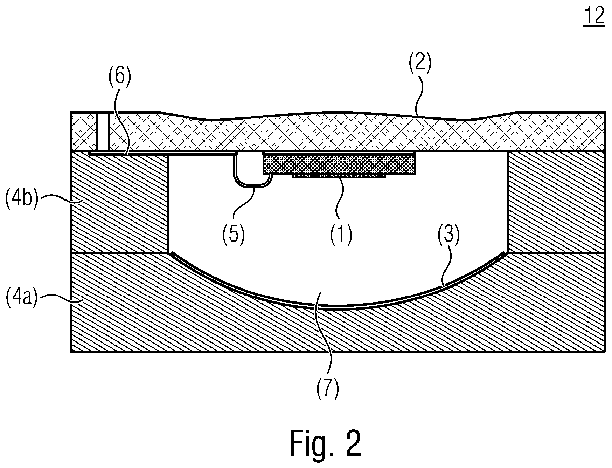

Fig. 2 zeigt eine schematische Seitenansicht eines Einzelkanals 12 des mehrkanaligen katadioptrischen Aufbaus (katadioptrische Multiaperturanordnung) (vgl. Fig.1) im Schnitt, gemäß einem Ausführungsbeispiel der vorliegenden Erfindung. Aufgrund der Aufbauweise des Kanals 12 mit dem Korrekturelement 2, dem Spiegelsubstrat 4a und dem Abstandssubstrat 4b wird eine Kavität 7 des Kanals erzielt, wodurch der sich im z.B. Vakuum oder Schutzgas befindliche Bildaufnehmer 1 geschützt ist und z.B. keine Feuchtigkeit kondensieren kann. Der optische Detektor (z.B. Bildaufnehmer) 1 kann auf der Rückseite des Korrekturelements 2 z.B. über Bonddrähte 5 und Leitungsbahnen mit einer Ausleseelektronik verbunden sein.

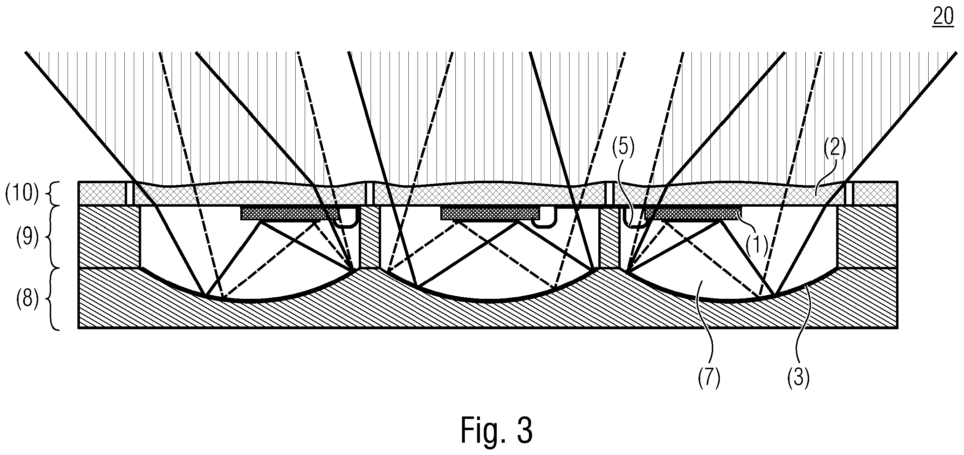

Fig. 3 zeigt eine schematische Seitenansicht des mehrkanaligen katadioptrischen Aufbaus (katadioptrische Multiaperturanordnung) 20 für drei exemplarische Kanäle zur Demonstration des segmentierten Gesichtsfeldes, gemäß einem Ausführungsbeispiel der vorliegenden Erfindung. Licht wird durch den Korrekturelementewafer 10 abgelenkt welcher z.B. individuell angepasste oder ähnliche optische Korrekturelemente 2 enthält. Dieser Korrekturelementewafer 10 dient gleichzeitig sowohl als infrarot optisches Fenster und generiert eine Kavität 7 der katadioptrischen Multiaperturanordnung in Verbindung mit dem Abstands- und Kanaltrennwafer 9 und dem Spiegelwafer 8. Das abgelenkte und vorkorrigierte Licht wird von dem optischen Spiegelelement (z.B. Freiformspiegel) 3 auf den optischen Detektor (z.B. Bildaufnehmer) 1 fokussiert, welcher auf der Rückseite des Korrekturelements 2 sitzt. Der Bildaufnehmer 1 kann über Bonddrähte 5 und Leitungsbahnen 6 mit einer Ausleseelektronik verbunden sein.

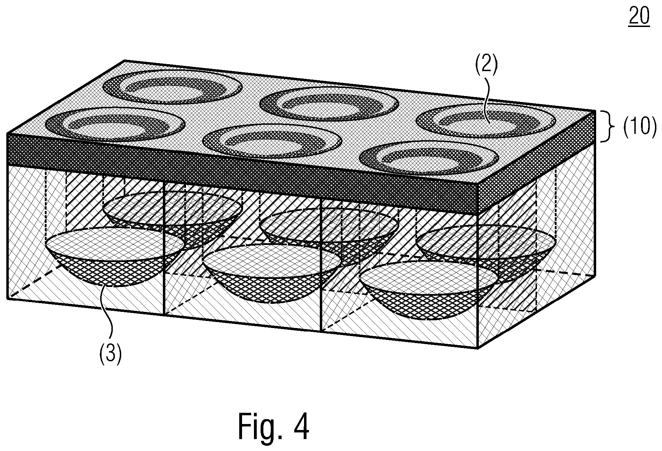

Fig. 4 zeigt eine dreidimensionale Ansicht des mehrkanaligen katadioptrischen Aufbaus (katadioptrische Multiaperturanordnung) 20 exemplarisch für 2 x 3 Kanäle, gem. einem Ausführungsbeispiel der vorliegenden Erfindung. Die sichtbaren Elemente sind die einzelnen optischen Spiegelelemente (z.B. Freiformspiegel) 3 für jeden einzelnen Kanal (vgl. Fig. 2) und der Korrekturelementewafer 10 mit den einzelnen unterschiedlich oder gleich gearteten Korrekturelementen 2. Je nach adressiertem Gesichtsfeld lassen sich durch die modulare Anordnung unterschiedliche Bild-Aspektverhältnisse realisieren.

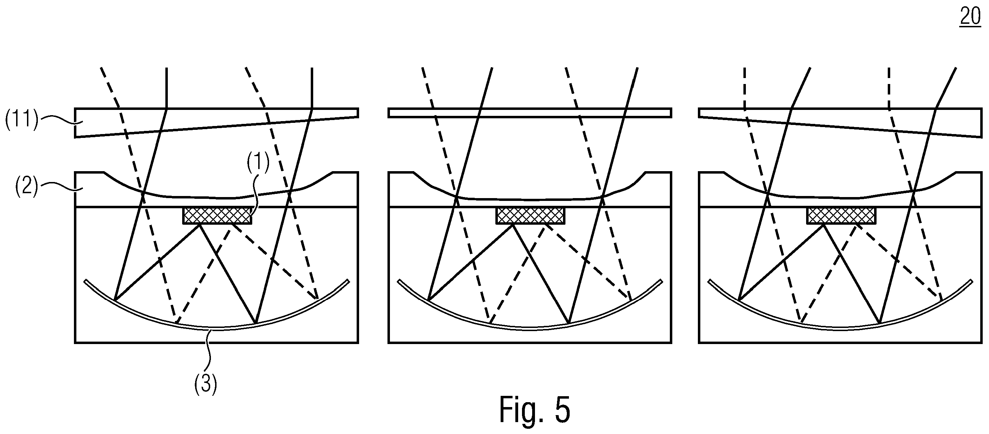

Fig. 5 zeigt eine schematische Querschnittansicht des mehrkanaligen katadioptrischen Aufbaus 20, gemäß einem Ausführungsbeispiel der vorliegenden Erfindung. Wie in Fig. 5 zu erkennen ist, kann der mehrkanalige katadioptrische Aufbau 20 eine Mehrzahl von Prismen 11 aufweisen, die benachbart zu der Mehrzahl von Korrekturelementen 2 angeordnet sind, so dass Mehrzahl von optischen Detektoren 1 jeweils einen unterschiedlichen Bildausschnitt des Infrarotbildes aufnehmen.

Bei Ausführungsbeispielen können die Mehrzahl von Prismen 11 in einem Prismenträger integriert sein. Alternativ können die Mehrzahl von Prismen auch in die Mehrzahl von Korrekturelementen 2 integriert sein.

Mit anderen Worten, Fig. 5 zeigt eine schematische Seitenansicht des mehrkanaligen katadioptrischen Aufbaus (katadioptrische Multiaperturanordnung) 20 im Schnitt für drei exemplarisch Kanäle zur Demonstration des segmentierten Gesichtsfeldes mittels eines vorgelagerten Prismenelementwafers mit Prismen 11. Licht wird durch das Prismenelement 11 umgelenkt und durch das Korrekturelement 2 abgelenkt, welches z.B. individuell angepasste oder ähnliche optische Korrekturfunktionen enthält. Das abgelenkte und vorkorrigierte Licht wird von dem optischen Spiegelelement (z.B. Freiformspiegel) 3 auf den optischen Detektor (z.B. Bildaufnehmer) 1 fokussiert, welcher auf der Rückseite des Korrekturelements 2 sitzt.

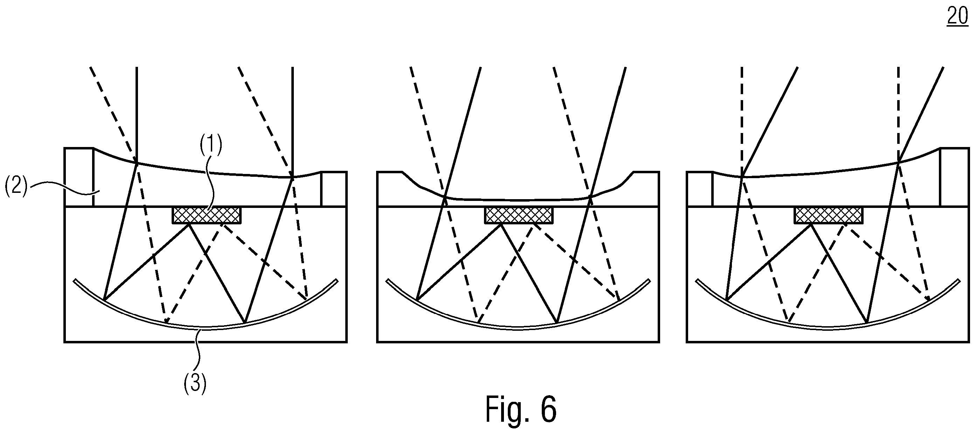

Fig. 6 zeigt eine schematische Querschnittansicht des mehrkanaligen katadioptrischen Aufbaus 20, gemäß einem Ausführungsbeispiel der vorliegenden Erfindung. Wie in Fig. 6 zu erkennen ist, können die Mehrzahl von optischen Korrekturelementen 2 ausgebildet sein, um unterschiedliche Bildausschnitte des Infrarotbildes auf die optischen Spiegelelemente 3 abzubilden, so dass durch die optischen Detektoren 1 unterschiedliche Bildausschnitte des Infrarotbildes erfasst werden.

Mit anderen Worten, Fig. 6 zeigt eine schematische Seitenansicht des mehrkanaligen katadioptrischen Aufbaus (katadioptrische Multiaperturanordnung) 20 im Schnitt für drei exemplarisch Kanäle zur Demonstration des segmentierten Gesichtsfeldes mittels eines Korrekturelements 2, welches eine zusätzliche ablenkende Wirkung wie die Prismenelemente 11 in Fig. 5 besitzt. Licht wird durch das Korrekturelement 2 umgelenkt und abgelenkt, welches z.B. individuell angepasste oder ähnliche optische Korrekturfunktionen enthält. Das abgelenkte und vorkorrigierte Licht wird von dem optischen Spiegelelement (z.B. Freiformspiegel) 3 auf den optischen Detektor (z.B. Bildaufnehmer) 1 fokussiert, welcher auf der Rückseite des Korrekturelements 2 sitzt.

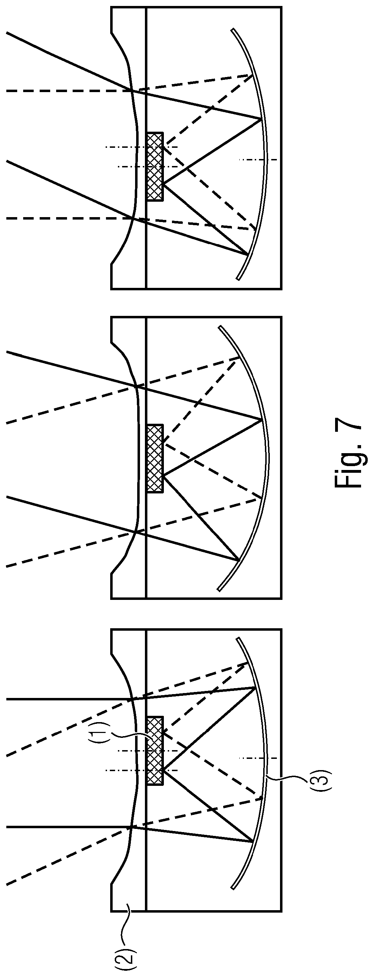

Fig. 7 zeigt eine schematische Querschnittansicht des mehrkanaligen katadioptrischen Aufbaus 20, gemäß einem Ausführungsbeispiel der vorliegenden Erfindung. Wie in Fig. 7 zu erkennen ist, können die Mehrzahl von optischen Detektoren 1 an der Mehrzahl von optischen Korrekturelementen 2 an unterschiedlichen Positionen angebracht sein, um jeweils einen unterschiedlichen Bildausschnitt des Infrarotbildes aufzunehmen.

Mit anderen Worten, Fig. 7 zeigt eine schematische Seitenansicht des mehrkanaligen katadioptrischen Aufbaus (katadioptrische Multiaperturanordnung) 20 im Schnitt für drei exemplarisch Kanäle zur Demonstration des segmentierten Gesichtsfeldes mittels nicht koinzident verlaufender optischer Achsen der einzelnen Elemente: Korrekturelement 2, optisches Spiegelelement (z.B. Freiformspiegel) 3 und optischer Detektor (z.B. Bildaufnehmer) 1. Durch die Verschiebung und/oder Richtungsänderung der jeweiligen Achsen kann die Blickrichtung der einzelnen Kanäle eingestellt werden. Individuelle Anpassung der optischen Korrekturfunktion und der Spiegelform.

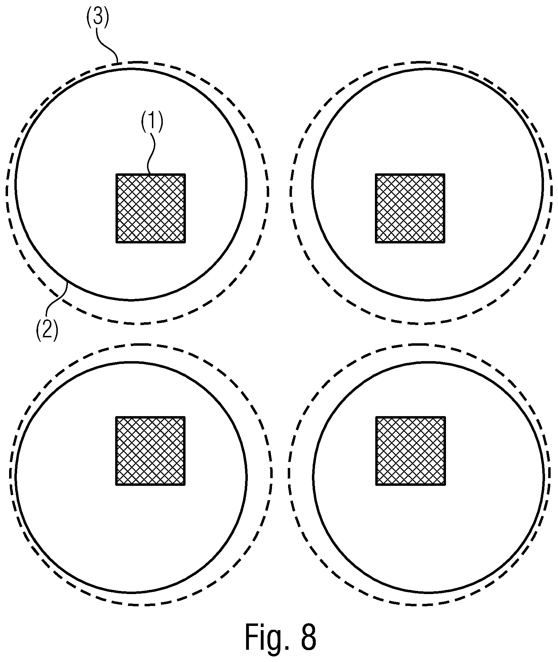

Fig. 8 zeigt eine Frontalansicht eines exemplarischen 2x2 Arrays des mehrkanaligen katadioptrischen Aufbaus (katadioptrische Multiaperturanordnung) 20, gem. einem Ausführungsbeispiel der vorliegenden Erfindung. Die sichtbaren Elemente sind die jeweiligen Korrekturelemente 2, optischen Spiegelelemente (z.B. Freiformspiegel) 3 und optischen Detektoren (z.B. Bildaufnehmer) 1 für jeden einzelnen Kanal. Innerhalb eines Kanals sind die Elemente 1, 2, und 3 zueinander verschoben, um das Gesichtsfeld zu segmentieren.

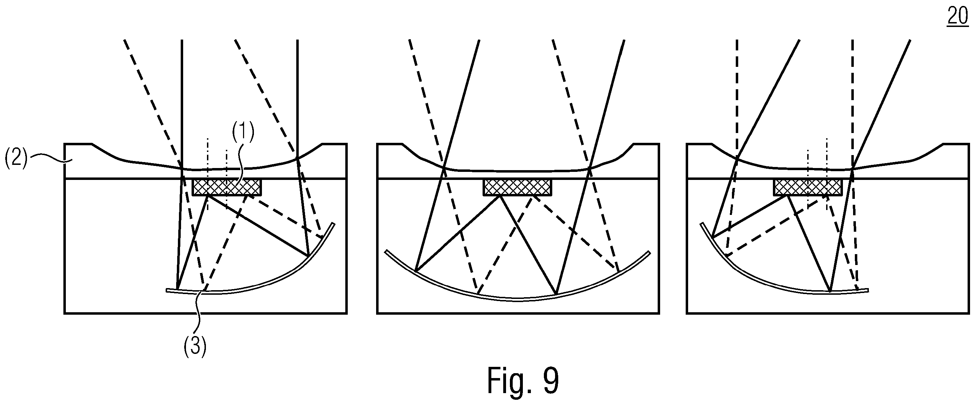

Fig. 9 zeigt eine schematische Querschnittansicht des mehrkanaligen katadioptrischen Aufbaus 20, gemäß einem Ausführungsbeispiel der vorliegenden Erfindung. Wie in Fig. 9 zu erkennen ist, können die Mehrzahl von Spiegelelementen 3 ausgebildet sein, um jeweils einen unterschiedlichen Bildausschnitt des Infrarotbildes auf den jeweiligen optischen Detektor 1 abzubilden.

Mit anderen Worten, Fig. 9 zeigt eine schematische Seitenansicht des mehrkanaligen katadioptrischen Aufbaus (katadioptrische Multiaperturanordnung) 20 im Schnitt für drei exemplarisch Kanäle zur Demonstration des segmentierten Gesichtsfeldes mittels nicht koinzident verlaufender optischer Achsen des Korrekturelements 2 und des optischen Detektors (z.B. Bildaufnehmers) 1 und eines off-axis asphärischen Spiegelelements oder Freiformelements 3. Individuelle Anpassung der optischen Korrekturfunktion und der Spiegelform.

Ausführungsbeispiele des hierin beschriebenen mehrkanaligen katadioptrischen Aufbaus (z.B. katadioptrische Multiaperturanordnung) bieten eine lichtstarke Optik (z.B. mit einer Blendenzahl ≤ 1,0 (bei geringer Sensorabschattung)) bei gleichzeitiger Reduktion der Aufbauhöhe sowie einer Verringerung der Komplexität des Optiksystems pro Kanal. Zusätzlich wird eine Vergrößerung des Gesichtsfeldes bei kleinen Einzelbildaufnehmern erreicht und ein modularer Aufbau in der Anzahl an Arrayelementen ermöglicht ein anpassbares Bild-Aspektverhältnis.

Bei Ausführungsbeispielen dient das optische Fenster als optische Korrekturplatte, Blickrichtungsänderung und zugleich als Montageplatte für den Bildaufnehmer, welches zusätzlich zur Vereinfachung des Optiksystems pro Kanal und gleichzeitiger Vakuum-/Schutzgasverkapselung des Gesamtsystems beiträgt.

Bei Ausführungsbeispielen hat jeder Kanal seinen eigenen Bildaufnehmer wodurch der Füllfaktor bei 100% im Vergleich zu einer Multiaperturoptik mit einem gemeinsamen Bildaufnehmer liegt. Außerdem kann prinzipiell kein Übersprechen der einzelnen Teilgesichtsfelder auftreten. Die dedizierten Bildaufnehmer können kleiner sein und lassen sich kostengünstiger fertigen.

Bei Ausführungsbeispielen lassen sich bei einer Berücksichtigung eines Überlapps von Teilgesichtsfeldern begrenzt räumliche Informationen (3D-Karten im Nahbereich) erfassen. Ausführungsbeispiele der vorliegenden Erfindung finden Anwendung bei IR-Wärmebildkameras für Automotive-Anwendungen; IR-Wärmebildkameras für Überwachungsaufgaben, Sicherheitsanwendungen und Inspektionen; IR-Detektoren / - Empfänger ohne Bildgebung; und/oder Multi- und Hyperspektralkameras.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele als Computerprogrammprodukt mit einem Programmcode implementiert sein, wobei der Programmcode dahingehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Ein weiteres Ausführungsbeispiel umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die hierin beschriebenen Vorrichtungen können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden.

### Literaturverzeichnis

[1] Yole Development, "Uncooled Infrared Imagers Report Technology", Marktstudie, 7. Edition, 2017
[2] FLIR Systems, Inc. Webseite: Kompakter LWIR-Wärmebildkamerakern - Boson (https://www.flir.de/products/boson/ ), 2018/09/03
[3] Eric Logean et al. "High numerical aperture silicon collimating lens for mid-infrared quantum cascade lasers manufactured using wafer-level techniques". Proc. SPIE 8550, Optical Systems Design 2012, 85500Q (December 18, 2012), doi:10.1117/12.981165.
[4] A. Portnoy, et. al., "Design and characterization of thin multiple aperture infrared cameras," Applied Optics Vol. 48, 2115-2126 (2009).
[5] Lightpath Webseite : (http://www.lightpath.com/product/ispoptics/)
[6] G. Druart et. al., "Demonstration of an infrared microcamera inspired by Xenos peckii vision," Applied Optics Vol. 48, No. 18 (2009).
[7] F. de la Barrière, et. al., "Compact infrared cryogenic wafer-level camera: design and experimental validation," Applied Optics Vol. 51, 1049-1060 (2012).
[8] F. de La Barrière, et. al., "Design strategies to simplify and miniaturize imaging systems." Applied optics 50.6 (2011): 943-951.
[9] T. Grulois, et. al., "Reduction of material mass of optical component in cryogenic camera by using high-order Fresnel lens on a thin germanium substrate," Appl. Opt. 54, 6313-6320 (2015).
[10] MAS ADRIEN ET AL: "Study of asymmetric or decentered multi-view designs for uncooled infrared imaging applications", OPTICS EXPRESS, Bd. 28, Nr. 23, 5. November 2020 (2020-11-05), Seite 35216, XP055926959
[11] Andreas Bru0ckner ET AL: "Multi-aperture optics for wafer-level cameras", Journal of Micro Nanolithography MEMS and MOEMS, 21. November 2011 (2011-11-21), Seite 43010, XP055128787

## Patentansprüche

1. Mehrkanaliger katadioptrischer Aufbau (20) zur Aufnahme eines Infrarotbildes, mit folgenden Merkmalen:
einer Mehrzahl von optischen Korrekturelementen (2a, 2b, 2c),
einer Mehrzahl von optischen Detektoren (1a, 1b, 1c), und
einer Mehrzahl von optischen Spiegelelementen (3a, 3b, 3c),
wobei die Mehrzahl von optischen Detektoren (1a, 1b, 1c) jeweils an einem der Mehrzahl von optischen Korrekturelementen (2a, 2b, 2c) angebracht oder integriert sind und jeweils zwischen einem der Mehrzahl von optischen Korrekturelementen (2a, 2b, 2c) und einem der Mehrzahl von optischen Spiegelelementen (3a, 3b, 3c) verkapselt sind,
wobei jeweils einer der Mehrzahl von optischen Detektoren (1a, 1b, 1c) zusammen mit einem jeweiligen optischen Korrekturelement und einem jeweiligen optischen Spiegelelement einen Kanal des mehrkanaligen (12a, 12b, 12c) katadioptrischen Aufbaus (20) bilden,
wobei die Mehrzahl von optischen Korrekturelementen (2a, 2b, 2c) auf einem gemeinsamen Korrekturelementträger (10) gebildet sind und/oder wobei die Mehrzahl von optischen Spiegelelementen (3a, 3b, 3c) auf einem gemeinsamen Spiegelelementträger (8) gebildet sind,
wobei die Mehrzahl von optischen Spiegelelementen (3a, 3b, 3c) ausgebildet sind, um einen jeweiligen Bildausschnitt des Infrarotbildes, der durch ein jeweiliges optisches Korrekturelement auf das jeweilige optische Spiegelelement abgebildet wird, auf einen jeweiligen optischen Detektor abzubilden.

2. Mehrkanaliger katadioptrischer Aufbau (20) nach Anspruch 1,
wobei die Mehrzahl von optischen Detektoren (1a, 1b, 1c) ausgebildet sind, um jeweils einen unterschiedlichen Bildausschnitt des Infrarotbildes aufzunehmen, wobei eine zusammengesetzte Version der unterschiedlichen Bildausschnitte das Infrarotbild bildet,
oder wobei zumindest zwei der Mehrzahl von optischen Detektoren (1a, 1b, 1c) ausgebildet sind, um denselben Bildausschnitt des Infrarotbildes aufzunehmen.

3. Mehrkanaliger katadioptrischer Aufbau (20) nach einem der vorangehenden Ansprüche,
wobei die Mehrzahl von optischen Korrekturelementen (2a, 2b, 2c) ausgebildet sind, um ein Sichtfeld des Infrarotbildes aufzuweiten,
und/oder wobei die Mehrzahl von optischen Detektoren (1a, 1b, 1c) in einem eindimensionalen oder zweidimensionalen Array angeordnet sind,
und/oder wobei die Mehrzahl von optischen Korrekturelementen (2a, 2b, 2c) und/oder die Mehrzahl von optischen Spiegelelementen (3a, 3b, 3c) in einem festen Verbund angeordnet sind,
und/oder wobei die Mehrzahl von optischen Korrekturelementen (2a, 2b, 2c) und/oder die Mehrzahl von optischen Detektoren (1a, 1b, 1c) und/oder die Mehrzahl von optischen Spiegelelementen (3a, 3b, 3c) in einer jeweiligen gemeinsamen Ebene angeordnet sind.

4. Mehrkanaliger katadioptrischer Aufbau (20) nach einem der vorangehenden Ansprüche,
wobei der Korrekturelementträger (10) und der Spiegelelementträger (8) über einen Abstandshalter (9) verbunden sind.

5. Mehrkanaliger katadioptrischer Aufbau (20) nach Anspruch 4,
wobei der Abstandhalter (9) für den Nutzwellenlängenbereich der optischen Detektoren (1a, 1b, 1c) optisch undurchlässig ist,
und/oder wobei der Korrekturelementträger (10), Spiegelelementträger (8) und der Abstandshalter (9) ein gekapseltes Gehäuse für die Mehrzahl von optischen Detektoren (1a, 1b, 1c) bilden,
und/oder wobei der Korrekturelementträger (10), Spiegelelementträger (8) und Abstandshalter (9) den gleichen thermischen Ausdehnungskoeffizienten oder aufeinander abgestimmte thermische Ausdehnungskoeffizienten aufweisen.

6. Mehrkanaliger katadioptrischer Aufbau (20) nach Anspruch 5,
wobei das gekapselte Gehäuse gasdicht realisiert ist und im Inneren ein Vakuum, Inertgas oder Schutzgas enthält,
und/oder wobei das gekapselte Gehäuse hermetisch dicht ist.

7. Mehrkanaliger katadioptrischer Aufbau (20) nach einem der vorangehenden Ansprüche,
wobei die Mehrzahl von Korrekturelementen (2a, 2b, 2c) eine refraktive und/oder diffraktive optische Funktionalität aufweisen,
und/oder wobei die Mehrzahl von Korrekturelementen (2a, 2b, 2c) eine Freiform- oder eine Fresnel-Struktur aufweisen,
und/oder wobei die reflektiven Spiegelelemente sphärische Oberflächenprofile, asphärische Oberflächenprofile und/oder Freiformoberflächenprofile aufweisen,
und/oder wobei die optischen Detektoren (1a, 1b, 1c) Fokalebenensensorelemente, Bolometer, halbleiterbasierte Detektoren (1a, 1b, 1c), pyroelektrische Detektoren (1a, 1b, 1c) oder Thermopile oder Kombinationen davon sind.

8. Mehrkanaliger katadioptrischer Aufbau (20) nach einem der vorangehenden Ansprüche 1 bis 7,
wobei die Mehrzahl von optischen Detektoren (1a, 1b, 1c) an der Mehrzahl von optischen Korrekturelementen (2a, 2b, 2c) an unterschiedlichen Positionen angebracht sind, um jeweils einen unterschiedlichen Bildausschnitt des Infrarotbildes aufzunehmen,
und/oder wobei die Mehrzahl von Spiegelelementen (3a, 3b, 3c) ausgebildet sind, um jeweils einen unterschiedlichen Bildausschnitt des Infrarotbildes auf den jeweiligen optischen Detektor abzubilden.

9. Mehrkanaliger katadioptrischer Aufbau (20) nach einem der vorangehenden Ansprüche 1 bis 7,
wobei der mehrkanalige katadioptrische Aufbau (20) eine Mehrzahl von Prismen aufweist, die benachbart zu der Mehrzahl von Korrekturelementen (2a, 2b, 2c) angeordnet sind oder in die Mehrzahl von Korrekturelementen (2a, 2b, 2c) integriert sind, so dass Mehrzahl von optischen Detektoren (1a, 1b, 1c) jeweils einen unterschiedlichen Bildausschnitt des Infrarotbildes aufnehmen.

10. Mehrkanaliger katadioptrischer Aufbau (20) nach Anspruch 9,
wobei die Mehrzahl von Prismen auf oder in einem gemeinsamen Prismenträger gebildet sind.

11. Mehrkanaliger katadioptrischer Aufbau (20) nach einem der vorangehenden Ansprüche,
wobei der mehrkanalige katadioptrische Aufbau (20) ferner eine Mehrzahl von optischen Filtern aufweist, die in den optischen Korrekturelementen (2a, 2b, 2c) oder den optischen Spiegelelementen (3a, 3b, 3c) integriert sind,
wobei die Mehrzahl von optischen Korrekturelementen (2a, 2b, 2c) entspiegelt sind,
und/oder wobei die Mehrzahl von optischen Korrekturelementen (2a, 2b, 2c) aus Silizium, Germanium oder Chalcogenidgläsern gefertig sind,
und/oder wobei die Mehrzahl von optischen Spiegelelementen (3a, 3b, 3c) eine Reflexion von mehr als 90% des Nutzwellenlängenbereichs der optischen Detektoren (1a, 1b, 1c) aufweisen.

12. Mehrkanaliger katadioptrischer Aufbau (20) nach dem vorangehenden Anspruch, wobei die Mehrzahl von optischen Filtern spektralselektiv und/oder polarisationsselektiv sind.

13. Verfahren zum Aufnehmen eines Infrarotbildes, wobei das Verfahren aufweist:
Aufnehmen des Infrarotbildes mit einem mehrkanaligen katadioptrischen Aufbau, wobei der mehrkanalige katadioptrische Aufbau (20) eine Mehrzahl von optischen Korrekturelementen (2a, 2b, 2c), eine Mehrzahl von optischen Detektoren (1a, 1b, 1c) und eine Mehrzahl von optischen Spiegelelementen (3a, 3b, 3c) aufweist, wobei die Mehrzahl von optischen Detektoren (1a, 1b, 1c) jeweils an einem der Mehrzahl von optischen Korrekturelementen (2a, 2b, 2c) angebracht sind und jeweils zwischen einem der Mehrzahl von optischen Korrekturelementen (2a, 2b, 2c) und einem der Mehrzahl von optischen Spiegelelementen (3a, 3b, 3c) verkapselt sind, wobei jeweils einer der Mehrzahl von optischen Detektoren (1a, 1b, 1c) zusammen mit einem jeweiligen optischen Korrekturelement und einem jeweiligen optischen Spiegelelement einen Kanal des mehrkanaligen katadioptrischen Aufbaus (20) bilden, wobei die Mehrzahl von optischen Spiegelelementen (3a, 3b, 3c) ausgebildet sind, um einen jeweiligen Bildausschnitt des Infrarotbildes, der durch ein jeweiliges optisches Korrekturelement auf das jeweilige optische Spiegelelement abgebildet wird, auf einen jeweiligen optischen Detektor abzubilden.

14. Verfahren nach Anspruch 13, wobei das Verfahren ferner aufweist:
Zusammensetzen der von den optischen Detektoren (1a, 1b, 1c) erfassten Bildausschnitte, um das Infrarotbild zu erhalten.

## Claims

1. Multi-channel catadioptric structure (20) for capturing an infrared image, comprising:
a plurality of optical correction elements (2a, 2b, 2c),
a plurality of optical detectors (1a, 1b, 1c), and
a plurality of optical mirror elements (3a, 3b, 3c),
wherein the plurality of optical detectors (1a, 1b, 1c) are each attached or integrated at one of the plurality of optical correction elements (2a, 2b, 2c), and are each encapsulated between one of the plurality of optical correction elements (2a, 2b, 2c) and one of the plurality of optical mirror elements (3a, 3b, 3c),
wherein a respective one of the plurality of optical detectors (1a, 1b, 1c) together with a respective optical correction element and a respective optical mirror element form a channel of the multi-channel (12a, 12b, 12c) catadioptric structure (20),
wherein the plurality of optical correction elements (2a, 2b, 2c) are formed on a mutual correction element carrier (10) and/or wherein the plurality of optical mirror elements (3a, 3b, 3c) are formed on a mutual mirror element carrier (8),
wherein the plurality of optical mirror elements (3a, 3b, 3c) is configured to image a respective image section of the infrared image, imaged by a respective optical correction element onto the respective optical mirror element, onto a respective optical detector.

2. Multi-channel catadioptric structure (20) according to claim 1,
wherein the plurality of optical detectors (1a, 1b, 1c) are configured to each capture a different image section of the infrared image, wherein a combined version of the different image sections forms the infrared image,
or wherein at least two of the plurality of optical detectors (1a, 1b, 1c) are configured to capture the same image section of the infrared image.

3. Multi-channel catadioptric structure (20) according to any of the preceding claims,
wherein the plurality of optical correction elements (2a, 2b, 2c) are configured to expand a field of view of the infrared image,
and/or wherein the plurality of optical detectors (1a, 1b, 1c) are arranged in a one-dimensional or two-dimensional array,
and/or wherein the plurality of optical correction elements (2a, 2b, 2c) and/or the plurality of optical mirror elements (3a, 3b, 3c) are arranged in a firm compound,
and/or wherein the plurality of optical correction elements (2a, 2b, 2c) and/or the plurality of optical detectors (1a, 1b, 1c) and/or the plurality of optical mirror elements (3a, 3b, 3c) are arranged in a respectively mutual plane.

4. Multi-channel catadioptric structure (20) according to any of the preceding claims,
wherein the correction element carrier (10) and the mirror element carrier (8) are connected via a spacer (9).

5. Multi-channel catadioptric structure (20) according to claim 4,
wherein the spacer (9) is optically impermeable for the usable wavelength range of the optical detectors (1a, 1b, 1c),
and/or wherein the correction element carrier (10), the mirror element carrier (8), and the spacer (9) form an encapsulated housing for the plurality of optical detectors (1a, 1b, 1c),
and/or wherein the correction element carrier (10), the mirror element carrier (8), and the spacer (9) comprise the same thermal expansion coefficient or thermal expansion coefficients that are tuned with respect to each other.

6. Multi-channel catadioptric structure (20) according to claim 5,
wherein the encapsulated housing is realized so as to be gas-tight and contains on its inside a vacuum, an inert gas, or a protective gas,
and/or wherein the encapsulated housing is hermetically tight.

7. Multi-channel catadioptric structure (20) according to any of the preceding claims,
wherein the plurality of correction elements (2a, 2b, 2c) comprise a refractive and/or diffractive optical functionality,
and/or wherein the plurality of correction elements (2a, 2b, 2c) comprise a free-form or a Fresnel structure,
and/or wherein the reflective mirror elements comprise spherical surface profiles, aspherical surface profiles, and/or free-form surface profiles,
and/or wherein the optical detectors (1a, 1b, 1c) are focal plane sensor elements, bolometers, semiconductor-based detectors (1a, 1b, 1c), pyroelectrical detectors (1a, 1b, 1c) or thermopiles or combinations thereof.

8. Multi-channel catadioptric structure (20) according to any of the preceding claims 1 to 7,
wherein the plurality of optical detectors (1a, 1b, 1c) are attached at the plurality of optical correction elements (2a, 2b, 2c) at different positions so as to each capture a different image section of the infrared image,
and/or wherein the plurality of mirror elements (3a, 3b, 3c) are configured to each image a different image section of the infrared image onto the respective optical detector.

9. Multi-channel catadioptric structure (20) according to any of the preceding claims 1 to 7,
wherein the multi-channel catadioptric structure (20) comprises a plurality of prisms arranged so as to be adjacent to the plurality of correction elements (2a, 2b, 2c) or integrated into the plurality of correction elements (2a, 2b, 2c) so that the plurality of optical detectors (1a, 1b, 1c) each capture a different image section of the infrared image.

10. Multi-channel catadioptric structure (20) according to claim 9,
wherein the plurality of prisms are formed on or in a mutual prism carrier.

11. Multi-channel catadioptric structure (20) according to any of the preceding claims,
wherein the multi-channel catadioptric structure (20) further comprises a plurality of optical filters integrated into the optical correction elements (2a, 2b, 2c) or the optical mirror elements (3a, 3b, 3c),
wherein the optical correction elements (2a, 2b, 2c) are non-reflecting,
and/or wherein the plurality of optical correction elements (2a, 2b, 2c) are made of silicon, germanium, or chalcogenide glasses,
and/or wherein the plurality of optical mirror elements (3a, 3b, 3c) comprise a reflection of more than 90% of the usable wavelength range of the optical detectors (1a, 1b, 1c).

12. Multi-channel catadioptric structure (20) according to the preceding claim,
wherein the plurality of optical filters is spectral-selective and/or polarization-selective.

13. Method for capturing an infrared image, the method comprising:
capturing the infrared image with a multi-channel catadioptric structure,
wherein the multi-channel catadioptric structure (20) comprises a plurality of optical correction elements (2a, 2b, 2c), a plurality of optical detectors (1a, 1b, 1c), and a plurality of optical mirror elements (3a, 3b, 3c), wherein the plurality of optical detectors (1a, 1b, 1c) are each arranged at one of the plurality of optical correction elements (2a, 2b, 2c) and are each encapsulated between one of the plurality of optical correction elements (2a, 2b, 2c) and one of the plurality of optical mirror elements (3a, 3b, 3c), wherein a respective one of the plurality of optical detectors (1a, 1b, 1c) together with a respective optical correction element and a respective optical mirror element form a channel of the multi-channel catadioptric structure (20),
wherein the plurality of optical mirror elements (3a, 3b, 3c) are configured to image a respective image section of the infrared image, imaged onto the respective optical mirror element by a respective optical correction element, onto a respective optical detector.

14. Method according to claim 13, the method further comprising:
combining the image sections captured by the optical detectors (1a, 1b, 1c) so as to obtain the infrared image.

## Revendications

1. Système catadioptrique multicanal (20) destiné à capturer une image infrarouge, avec les caractéristiques suivantes :
une pluralité d'éléments de correction optique (2a, 2b, 2c),
une pluralité de détecteurs optiques (1a, 1b, 1c), et
une pluralité d'éléments de miroir optique (3a, 3b, 3c),
dans lequel chaque détecteur de la pluralité de détecteurs optiques (1a, 1b, 1c) est respectivement fixé ou intégré sur un élément de la pluralité d'éléments de correction optique (2a, 2b, 2c) et respectivement encapsulé entre un élément de la pluralité d'éléments de correction optique (2a, 2b, 2c) et un élément de la pluralité d'éléments de miroir optique (3a, 3b, 3c),
dans lequel chaque détecteur de la pluralité de détecteurs optiques (1a, 1b, 1c) conjointement avec un élément de correction optique respectif et un élément de miroir optique respectif forme un canal du système catadioptrique (20) multicanal (12a, 12b, 12c),
dans lequel la pluralité d'éléments de correction optique (2a, 2b, 2c) est formée sur un support d'éléments de correction commun (10) et/ou dans lequel la pluralité d'éléments de miroir optique (3a, 3b, 3c) est formée sur un support d'éléments de miroir commun (8),
dans lequel la pluralité d'éléments de miroir optique (3a, 3b, 3c) est conçue pour reproduire sur un détecteur optique respectif une section d'image respective de l'image infrarouge, laquelle est reproduite par un élément de correction optique respectif sur l'élément de miroir optique respectif.

2. Système catadioptrique multicanal (20) selon la revendication 1, dans lequel chaque détecteur de la pluralité de détecteurs optiques (1a, 1b, 1c) est conçu pour capturer respectivement une section d'image différente de l'image infrarouge, dans lequel une version composée des différentes sections d'image forme l'image infrarouge.
ou dans lequel au moins deux détecteurs de la pluralité de détecteurs optiques (1a, 1 b, 1c) sont conçus pour capturer la même section d'image de l'image infrarouge.

3. Système catadioptrique multicanal (20) selon l'une des revendications précédentes,
dans lequel la pluralité d'éléments de correction optique (2a, 2b, 2c) est conçue pour élargir un champ optique de l'image infrarouge,
et/ou dans lequel la pluralité de détecteurs optiques (1a, 1b, 1c) est disposée dans un réseau unidimensionnel ou bidimensionnel,
et/ou dans lequel la pluralité d'éléments de correction optique (2a, 2b, 2c) et/ou la pluralité d'éléments de miroir optique (3a, 3b, 3c) est disposée dans un assemblage fixe,
et/ou dans lequel la pluralité d'éléments de correction optique (2a, 2b, 2c) et/ou la pluralité de détecteurs optiques (1a, 1b, 1c) et/ou la pluralité d'éléments de miroir optique (3a, 3b, 3c) est disposée dans un plan commun respectif.

4. Système catadioptrique multicanal (20) selon l'une des revendications précédentes,
dans lequel le support d'éléments de correction (10) et le support d'éléments de miroir (8) sont reliés par l'intermédiaire d'un moyen d'espacement (9).

5. Système catadioptrique multicanal (20) selon la revendication 4, dans lequel le moyen d'espacement (9) est optiquement non-traversant pour la plage de longueurs d'onde utiles des détecteurs optiques (1a, 1b, 1c),
et/ou dans lequel le support d'éléments de correction (10), le support d'éléments de miroir (8) et le moyen d'espacement (9) forment un boîtier encapsulé pour la pluralité de détecteurs optiques (1a, 1b, 1c),
et/ou dans lequel le support d'éléments de correction (10), le support d'éléments de miroir (8) et le moyen d'espacement (9) présentent le même coefficient de dilatation thermique ou des coefficients de dilatation thermique coordonnés les uns aux autres.

6. Système catadioptrique multicanal (20) selon la revendication 5,
dans lequel le boîtier encapsulé est réalisé de manière étanche aux gaz et contient un vide, un gaz inerte ou un gaz protecteur à l'intérieur,
et/ou dans lequel le boîtier encapsulé est étanche hermétiquement.

7. Système catadioptrique multicanal (20) selon l'une des revendications précédentes,
dans lequel la pluralité d'éléments de correction (2a, 2b, 2c) présente une fonctionnalité optique réfractive et/ou diffractive.
et/ou dans lequel la pluralité d'éléments de correction (2a, 2b, 2c) présente une structure de forme libre ou de Fresnel,
et/ou dans lequel les éléments de miroir réfléchissants présentent des des profils de surface sphériques, des profils de surface asphériques et/ou des profils de surface de forme libre,
et/ou dans lequel les détecteurs optiques (1a, 1 b, 1c) sont des éléments de capteur à plan focal, des bolomètres, des détecteurs à semiconducteur (1a, 1b, 1c), des détecteurs pyroélectriques (1a, 1b, 1c) ou des thermopiles ou des combinaisons de ceux-ci.

8. Système catadioptrique multicanal (20) selon l'une des revendications précédentes 1 à 7,
dans lequel la pluralité de détecteurs optiques (1a, 1b, 1c) est fixée sur la pluralité d'éléments de correction optique (2a, 2b, 2c) en différentes positions pour capturer respectivement une section d'image différente de l'image infrarouge,
et/ou dans lequel la pluralité d'éléments de miroir (3a, 3b, 3c) est conçue pour reproduire respectivement une section d'image différente de l'image infrarouge sur le détecteur optique respectif.

9. Système catadioptrique multicanal (20) selon l'une des revendications précédentes 1 à 7,
dans lequel le système catadioptrique multicanal (20) présente une pluralité de prismes qui sont disposés de manière adjacente à la pluralité d'éléments de correction (2a, 2b, 2c) ou sont intégrés dans la pluralité d'éléments de correction (2a, 2b, 2c) de telle sorte que la pluralité de détecteurs optiques (1a, 1b, 1c) capture respectivement une section d'image différente de l'image infrarouge.

10. Système catadioptrique multicanal (20) selon la revendication 9,
dans lequel la pluralité de prismes est formée sur ou dans un support de prismes commun.

11. Système catadioptrique multicanal (20) selon l'une des revendications précédentes,
dans lequel le système catadioptrique multicanal (20) présente en outre une pluralité de filtres optiques qui sont intégrés dans les éléments de correction optique (2a, 2b, 2c) ou les éléments de miroir optique (3a, 3b, 3c),
dans lequel la pluralité d'éléments de correction optique (2a, 2b, 2c) est antireflet,
et/ou dans lequel la pluralité d'éléments de correction optique (2a, 2b, 2c) est constituée de silicium, de germanium ou de verres de chalcogénure,
et/ou dans lequel la pluralité d'éléments de miroir optique (3a, 3b, 3c) présente une réflexion supérieure à 90 % de la plage de longueurs d'onde utiles des détecteurs optiques (1a, 1b, 1c).

12. Système catadioptrique multicanal (20) selon la revendication précédente,
dans lequel la pluralité de filtres optiques est sélective spectralement et/ou sélective en polarisation.

13. Procédé destiné à capturer une image infrarouge, dans lequel le procédé présente :
capturer l'image infrarouge avec un système catadioptrique multicanal,
dans lequel le système catadioptrique multicanal (20) présente une pluralité d'éléments de correction optique (2a, 2b, 2c), une pluralité de détecteurs optiques (1a, 1 b, 1c) et une pluralité d'éléments de miroir optiques (3a, 3b, 3c),
dans lequel chaque détecteur de la pluralité de détecteurs optiques (1a, 1b, 1c) est respectivement fixé sur un élément de la pluralité d'éléments de correction optique (2a, 2b, 2c) et respectivement encapsulé entre un élément de la pluralité d'éléments de correction optique (2a, 2b, 2c) et un élément de la pluralité d'éléments d'éléments de miroir optiques (3a, 3b, 3c),
dans lequel chaque détecteur de la pluralité de détecteurs optiques (1a, 1b, 1c) conjointement avec un élément de correction optique respectif et un élément de miroir optique respectif forme un canal du système catadioptrique multicanal (20),
dans lequel la pluralité d'éléments de miroir optiques (3a, 3b, 3c) est conçue pour reproduire reproduire sur un détecteur optique respectif une section d'image respective de l'image infrarouge, laquelle est reproduite par un élément de correction optique respectif sur l'élément de miroir optique respectif.

14. Procédé selon la revendication 13, dans lequel le procédé présente en outre :
composer les sections d'image enregistrées par les détecteurs optiques (1a, 1b, 1c) pour obtenir l'image infrarouge.
